# EUROPEAN PATENT APPLICATION

(11) **EP 4 482 263 A1**
(43) Date of publication of application: **25.12.2024**
(21) Application number: 24152576.5
(22) Date of filing: 18.01.2024
(51) Int. Cl.: H05K 1/14, H05K 7/14, G11C 5/04

(54) **SEMICONDUCTOR MEMORY MODULE INCLUDING FIXING STRUCTURE**

(30) Priority: 21.06.2023 KR 20230079770
(71) Applicant: Samsung Electronics Co., Ltd., Suwon-si, Gyeonggi-do 16677 (KR)
(72) Inventor: NOH, Hyunggyun, 16677 Suwon-si, Gyeonggi-do (KR); BAE, Jinsoo, 16677 Suwon-si, Gyeonggi-do (KR); RHEW, Keun-Ho, 16677 Suwon-si, Gyeonggi-do (KR); CHOI, Deok-Seon, 16677 Suwon-si, Gyeonggi-do (KR); CHOE, Jongchan, 16677 Suwon-si, Gyeonggi-do (KR)
(74) Representative: Kuhnen & Wacker Patent- und Rechtsanwaltsbüro PartG mbB

(57) **Abstract**

A semiconductor memory module is disclosed. The semiconductor memory module 1000 includes a first substrate including a first corner CR1, first semiconductor packages mounted on a lower surface of the first substrate, a second substrate 200 disposed over the first substrate and including a second corner CR2 corresponding to the first corner, second semiconductor packages 50 mounted on an upper surface of the second substrate 200, and a fixing structure 400 in which the first corner CR1 and the second corner CR2 are fitted.

## Description

### CROSS-REFERENCE TO RELATED APPLICATIONS

This U.S. non-provisional patent application claims priority under 35 U.S.C.§119 to Korean Patent Application No. 10-2023-0079770, filed on June 21, 2023, in the Korean Intellectual Property Office, the entire contents of which are hereby incorporated by reference.

### BACKGROUND OF THE INVENTION

The inventive concepts relate to a semiconductor memory module, and more particularly, relate to a semiconductor memory module having improved reliability.

Many electronic systems include semiconductor memory modules, such as solid state drives (SSDs), dual in-line memory modules (DIMMs), and small outline-DIMMs, all of which utilize memory cells to store data as an electrical charge or voltage. Improvements in storage density of these modules have been brought about by increasing the density of the memory cells on each individual memory component using enhanced manufacturing techniques. Additionally, the storage density of these modules has also been increased by including more memory components in each memory device or module using advanced board-level packaging techniques.

### SUMMARY

An object of the inventive concepts is to provide a semiconductor memory module with improved reliability.

The benefits provided by the inventive concepts are not limited to addressing the problems mentioned above, and other benefits not mentioned will be clearly understood by those skilled in the art from the description below.

A semiconductor memory module according to some embodiments of the inventive concepts includes a first substrate including a first corner, first semiconductor packages mounted on a lower surface of the first substrate, a second substrate disposed over the first substrate and including a second corner corresponding to the first corner, second semiconductor packages mounted on an upper surface of the second substrate, and a fixing structure into which the first corner and the second corner are fitted.

A semiconductor memory module according to some embodiments of the inventive concepts includes a case and a stacked structure housed therein, wherein the stacked structure includes a first substrate including a plurality of first corners and having a first side surface and a second side surface, first semiconductor packages mounted on a lower surface of the first substrate, second semiconductor packages mounted on an upper surface of the first substrate, a second substrate disposed over the first substrate, including a plurality of second corners with each second corner respectively corresponding to a respective first corner, and having a third side surface and a fourth side surface, third semiconductor packages mounted on an upper surface of the second substrate, a plurality of fixing structures in which corresponding pairs of the first corners and the second corners are fitted in a respective fixing structure of the plurality of fixing structures, a frame interposed between the first substrate and the second substrate, at least one flexible connector connecting the second side surface and the fourth side surface, and at least one capacitor connected to the first side surface, wherein a length, width or height of each of the fixing structures is in a range from 0.1 mm to 200 mm, wherein at least one fixing structure of the plurality of fixing structures includes a first slot into which one of the first corners is fitted and a second slot in which one of the second corners is fitted, and wherein the distance between the first slot and the second slot is in a range from 0.1 mm to 100 mm.

A semiconductor memory module according to some embodiments of the inventive concepts includes a first substrate including a first corner and a first side surface, first semiconductor packages mounted on a lower surface of the first substrate, a second substrate disposed over the first substrate and including a second corner and a second side surface respectively corresponding to the first corner and the first side surface, second semiconductor packages mounted on an upper surface of the second substrate, a fixing structure in which the first corner and the second corner are inserted, the fixing structure fixing a distance between the first substrate and the second substrate, and at least one flexible connector connecting the first side surface and the second side surface.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a plan view of a semiconductor memory module according to embodiments of the inventive concepts.
FIG. 2 is a cross-sectional view of FIG. 1 taken along line A-A' according to embodiments of the inventive concepts.
FIG. 3 is a cross-sectional view of FIG. 1 taken along line B-B' according to embodiments of the inventive concepts.
FIG. 4 is a cross-sectional view of FIG. 1 taken along line C-C' according to embodiments of the inventive concepts.
FIGS. 5A and 5B are perspective views of flexible connectors according to embodiments of the inventive concepts.
FIG. 6A is a perspective view of the semiconductor memory module of FIG. 1.
FIG. 6B is an exploded perspective view of the semiconductor memory module of FIG. 1.
FIGS. 7A to 7H are perspective views of fixing structures according to embodiments of the inventive concepts.
FIG. 8 is a cross-sectional view of FIG. 1 taken along line B-B' according to embodiments of the inventive concepts.
FIG. 9 is a plan view illustrating a state of components of a semiconductor memory module during a process of manufacturing a semiconductor memory module.
FIG. 10 is a cross-sectional view of FIG. 9 taken along line A-A'.
FIG. 11 is a cross-sectional view illustrating a state of components of a semiconductor memory module during a process of manufacturing a semiconductor memory module.
FIG. 12 is a plan view of a semiconductor memory module according to embodiments of the inventive concepts.
FIG. 13 is a cross-sectional view of FIG. 12 taken along line B-B' according to embodiments of the inventive concepts.
FIG. 14 is a plan view of a semiconductor memory module according to embodiments of the inventive concepts.
FIG. 15 is a cross-sectional view of FIG. 14 taken along line A-A' according to embodiments of the inventive concepts.
FIG. 16 is a cross-sectional view of FIG. 14 taken along line B-B' according to embodiments of the inventive concepts.

### DETAILED DESCRIPTION

Hereinafter, to explain the inventive concepts in detail, embodiments according to the inventive concepts will be described with reference to the accompanying drawings. The inventive concept may, however, be embodied in many different forms and should not be construed as limited to the example embodiments set forth herein. These example embodiments are just that - examples - and many implementations and variations are possible that do not require the details provided herein. It should also be emphasized that the disclosure provides details of alternative examples, but such listing of alternatives is not exhaustive. Furthermore, any consistency of detail between various examples should not be interpreted as requiring such detail - it is impracticable to list every possible variation for every feature described herein. The language of the claims should be referenced in determining the requirements of the invention.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Items described in the singular herein may be provided in plural, as can be seen, for example, in the drawings. Thus, the description of a single item that is provided in plural should be understood to be applicable to the remaining plurality of items unless context indicates otherwise.

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures. Also, these spatially relative terms such as "above" and "below" as used herein have their ordinary broad meanings-for example element A can be above element B even if when looking down on the two elements there is no overlap between them (just as something in the sky is generally above something on the ground, even if it is not directly above).

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" share a common electrical node through electrical connections by one or more conductors, such as, for example, wires, pads, internal electrical lines, through vias, etc. As such, directly electrically connected components do not include components electrically connected through active elements, such as transistors or diodes.

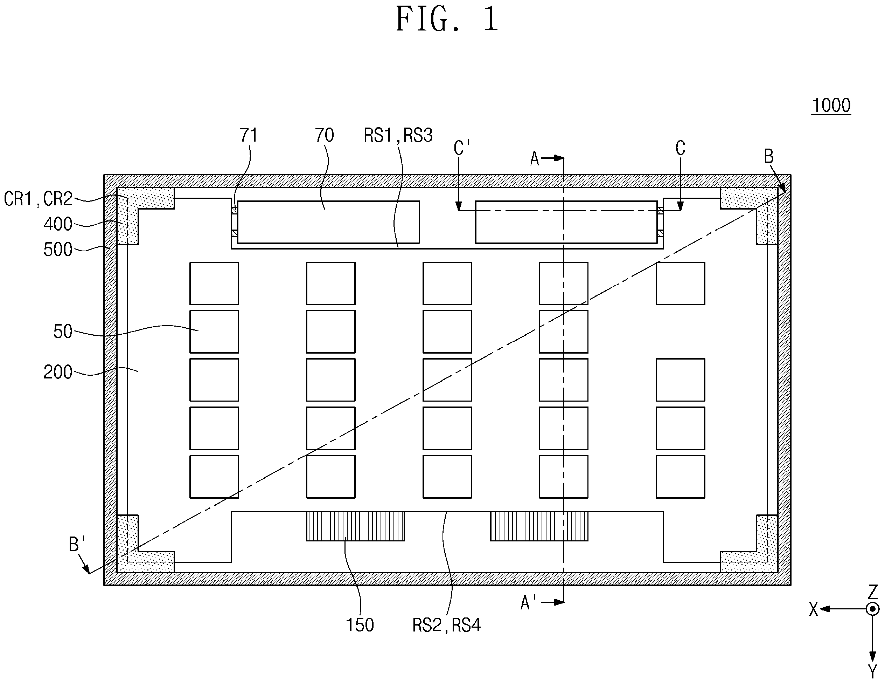

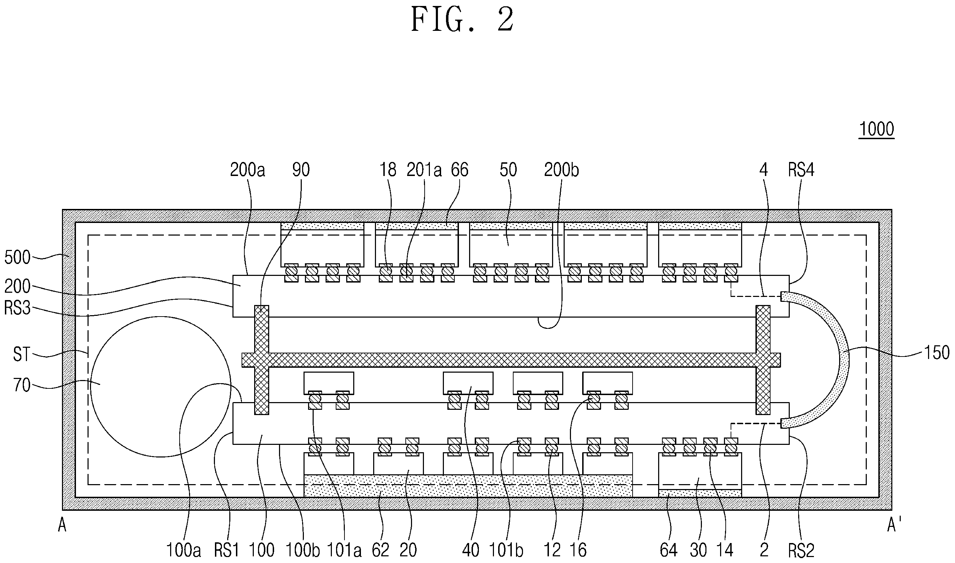

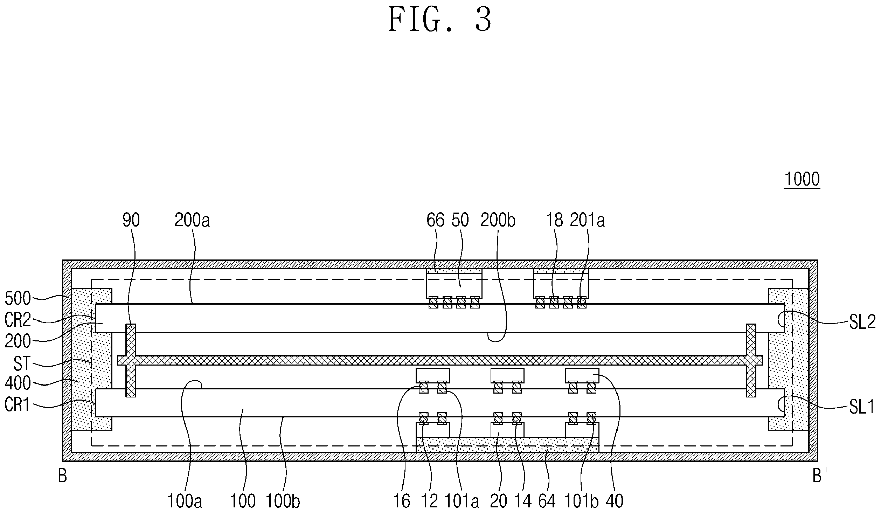

FIG. 1 is a plan view of a semiconductor memory module according to embodiments of the inventive concepts. FIG. 2 is a cross-sectional view of FIG. 1 taken along line A-A' according to embodiments of the inventive concepts. FIG. 3 is a cross-sectional view of FIG. 1 taken along line B-B' according to embodiments of the inventive concepts.

Referring to FIGS. 1 to 3, a semiconductor memory module 1000 according to the inventive concepts may be, for example, a solid state drive (SSD), a dual inline memory module (DIVIM), or a small outline DIVIM. A semiconductor memory module 1000 according to the inventive concepts includes a case 500 and a stacked structure ST inserted therein (e.g., the case may house the stacked structure ST). In the semiconductor memory module 1000 according to some of the inventive concepts, the case 500 may be excluded. The stacked structure ST includes a first substrate 100 and a second substrate 200 sequentially stacked. The first substrate 100 and the second substrate 200 may be, for example, double-sided or multi-layered printed circuit boards.

The first substrate 100 may have a first upper surface 100a and a first lower surface 100b. First upper conductive pads 101a are disposed on the first upper surface 100a of the first substrate 100. First lower conductive pads 101b are disposed on the first lower surface 100b of the first substrate 100. A first internal wiring 2 may be disposed in the first substrate 100. The first substrate 100 may have four first corners CR1 arranged in a clockwise direction. The first substrate 100 may have a first side surface RS 1 and a second side surface RS2 opposite to each other. When viewed in a plan view, the first side surface RS1 and the second side surface RS2 of the first substrate 100 may be recessed toward a center of the first substrate 100.

The second substrate 200 may have a second upper surface 200a and a second lower surface 200b. Second upper conductive pads 201a are disposed on the second upper surface 200a of the second substrate 200. A second internal wiring 4 may be disposed in the second substrate 200. Although not shown, second lower conductive pads may also be disposed on the second lower surface 200b of the second substrate 200. The second substrate 200 may have four second corners CR2 arranged in a clockwise direction. The second corners CR2 are positioned over the first corners CR1 and each second corner CR1 may overlap (or correspond to) a respective first corner CR1. The second substrate 200 may have a third side surface RS3 and a fourth side surface RS4 opposite to each other. When viewed in a plan view, the third side surface RS3 and the fourth side surface RS4 of the second substrate 200 may be recessed toward a center of the second substrate 200. The third side surface RS3 may be disposed over the first side surface RS1 and may overlap the first side surface RS1 in a vertical direction. The fourth side surface RS4 may be disposed over the second side surface RS2 and may overlap the second side surface RS2 in a vertical direction.

First semiconductor packages 20 and at least one second semiconductor package 30 may be mounted on the first lower surface 100b of the first substrate 100. The first semiconductor packages 20 may be bonded to some of the first lower conductive pads 101b through first solder balls 12. The second semiconductor package 30 may be bonded to other portions of the first lower conductive pads 101b through second solder balls 14. Third semiconductor packages 40 may be disposed on the first upper surface 100a of the first substrate 100. The third semiconductor packages 40 may be bonded to other portions of the first upper conductive pads 101a through third solder balls 16.

Fourth semiconductor packages 50 may be mounted on the second upper surface 200a of the second substrate 200. The fourth semiconductor packages 50 may be bonded to some of the second upper conductive pads 201a through fourth solder balls 18. At least one of the first to fourth semiconductor packages 20, 30, 40, and 50 may independently be system large scale integration (LSI) chips or logic circuit chips. Alternatively, other semiconductor packages of the first to fourth semiconductor packages 20, 30, 40, and 50 may independently be NAND flash memory chips, DRAM chips, SRAM chips, EEPROM chips, PRAM chips, MRAM chips, ReRAM chips, high bandwidth memory (HBM) chips, and hybrid memory cubic (HMC) chips. The other semiconductor packages of the first to fourth semiconductor packages 20, 30, 40, and 50 may independently be a microelectromechanical system (MEMS) device chip or an application-specific integrated circuit (ASIC) chip. At least one of the first to fourth semiconductor packages 20, 30, 40, and 50 may be replaced with a passive element. The passive element may be a capacitor or resistor.

A first thermal interface material layer 62 may be interposed between the first semiconductor packages 20 and the case 500. A second thermal interface material layer 64 may be interposed between the second semiconductor package 30 and the case 500. A third thermal interface material layer 66 may be interposed between the fourth semiconductor packages 50 and the case 500. The thicknesses of the first thermal interface material layer 62, the second thermal interface material layer 64, and the third thermal interface material layer 66 may be different from each other. For example, the thickness of the first thermal interface material layer 62 may be greater than that of the second thermal interface material layer 64. The densities of the first thermal interface material layer 62, the second thermal interface material layer 64, and the third thermal interface material layer 66 may be different from each other. For example, the density of the first thermal interface material layer 62 may be higher than that of the second thermal interface material layer 64. The first thermal interface material layer 62, the second thermal interface material layer 64, and the third thermal interface material layer 66 may include a thermosetting resin layer. The first thermal interface material layer 62, the second thermal interface material layer 64, and the third thermal interface material layer 66 may further include filler particles dispersed in the thermosetting resin layer. The filler particles may include at least one of silica, alumina, zinc oxide, and nitrogen boride.

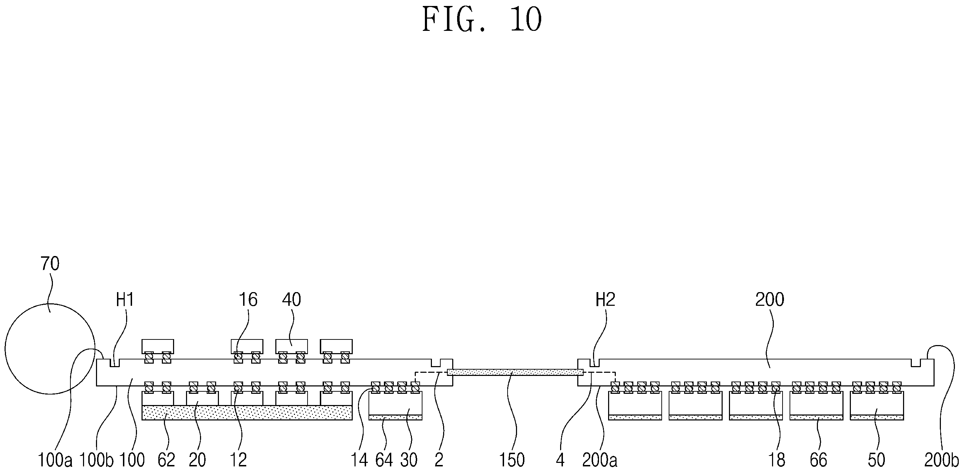

A first frame 90 may be interposed between the first substrate 100 and the second substrate 200. The first frame 90 may maintain a space between the first substrate 100 and the second substrate 200 at a certain distance or greater. A portion of the first frame 90 may be inserted into first grooves (H1 in FIG. 10) disposed on the first upper surface 100a of the first substrate 100. Another portion of the first frame 90 may be inserted into the second grooves (H2 in FIG. 10) disposed on the second lower surface 200b of the second substrate 200. The first frame 90 may be formed of and/or include ceramic, plastic, or metal. The first frame 90 may be spaced apart from the first to fourth semiconductor packages 20, 30, 40, and 50 (e.g., the first frame 90 does not contact the first to fourth semiconductor packages 20, 30, 40, and 50).

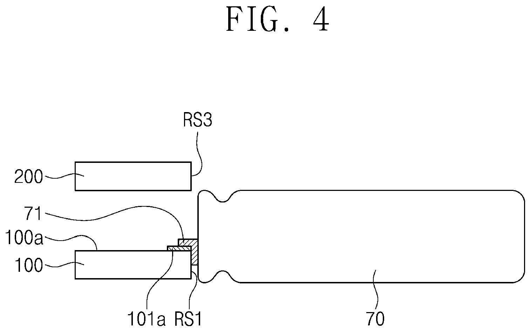

FIG. 4 is a cross-sectional view of FIG. 1 taken along line C-C' according to embodiments of the inventive concepts.

Referring to FIGS. 1, 2 and 4, the semiconductor memory module 1000 according to the inventive concepts may further include at least one capacitor 70. In the present example, two capacitors 70 may be provided but more than two capacitors 70 are possible in other examples. The capacitor 70 may include two connection terminals 71. The connection terminal 71 may have an 'L' shape. The capacitor 70 may be bonded to a recessed first side surface RS1 of the first substrate 100. The connection terminal 71 of the capacitor 70 may be bonded to the first upper conductive pad 101a adjacent to the first side surface RS1. Although not shown, a solder layer may be interposed between the connection terminal 71 and the first upper conductive pad 101a. The capacitor 70 may be disposed in a space provided by the recessed first side surface RS1, and an upper portion of the capacitor 70 may be inserted into the space provided by the recessed third side surface RS3. The capacitor 70 may not protrude beyond the outermost side surfaces of the first substrate 100 and the second substrate 200 due to the recessed first side surfaces RS1 and RS3 of the first substrate 100 and the second substrate 200. Because the capacitor 70 may not protrude beyond the outermost surfaces of the first substrate 100 and the second substrate 200, the overall size of the semiconductor memory module 1000 may be reduced.

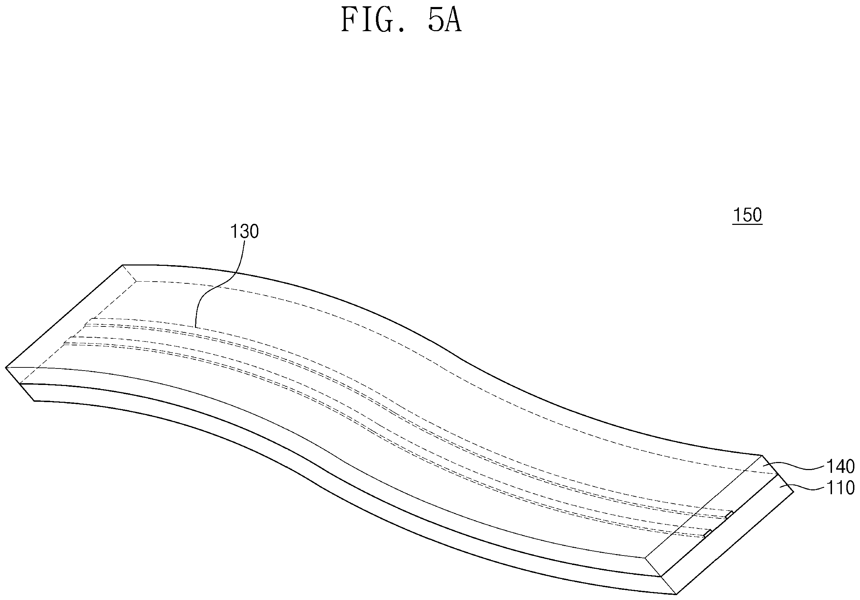

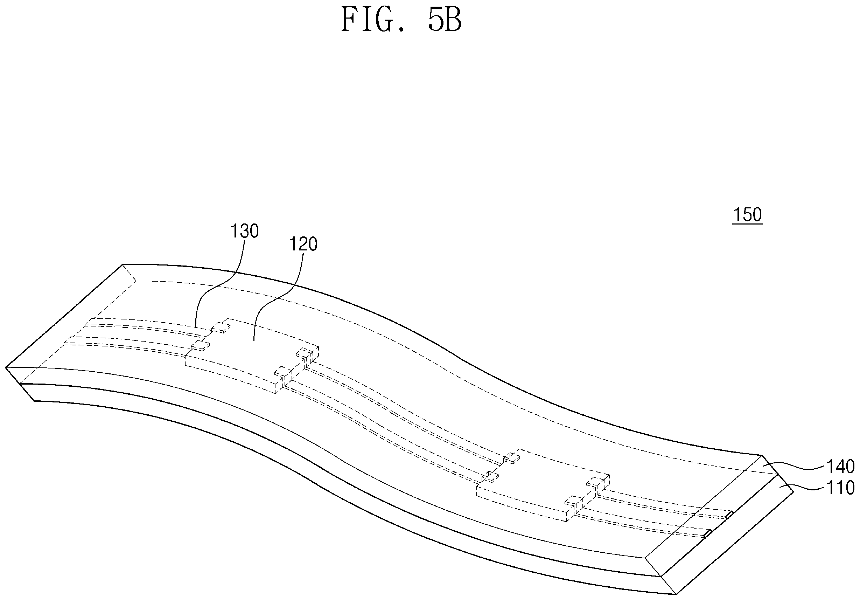

FIGS. 5A and 5B are perspective views of flexible connectors according to embodiments of the inventive concepts.

Referring to FIGS. 1, 2, and 5A and 5B, the semiconductor memory module 1000 according to the inventive concepts may further include at least one first flexible connector 150. In the present example, two first flexible connectors 150 may be provided. The first flexible connector 150 may connect the recessed second side surface RS2 of the first substrate 100 and the recessed fourth side surface RS4 of the second substrate 200. The first flexible connector 150 may be disposed in spaces provided by the recessed second and fourth side surfaces RS2 and RS4. As a result, the first flexible connector 150 may not protrude outside the outermost periphery of the first substrate 100 and the second substrate 200, and thus the overall size of the semiconductor memory module 1000 may be reduced. In the present specification, a 'flexible connector' may also be referred to as a 'flexible substrate'.

As shown in FIG. 5A, the first flexible connector 150 may include a first flexible layer 110 and a second flexible layer 140 sequentially stacked, and flexible wirings 130 interposed therebetween. The flexible wirings 130 may include a metal such as copper. The first flexible layer 110 and the second flexible layer 140 may be formed of and/or include polyimide or a polymer material. The first internal wiring 2 of the first substrate 100 of FIG. 2 may be connected to the second internal wiring 4 of the second substrate 200 of FIG. 2 by the flexible wirings 130. As another example, the first flexible connector 150 may further include at least one active element 120 disposed between the first flexible layer 110 and the second flexible layer 140 and connected to the flexible wirings 130. The active element 120 may be one of a logic chip, a memory chip, and a processor chip.

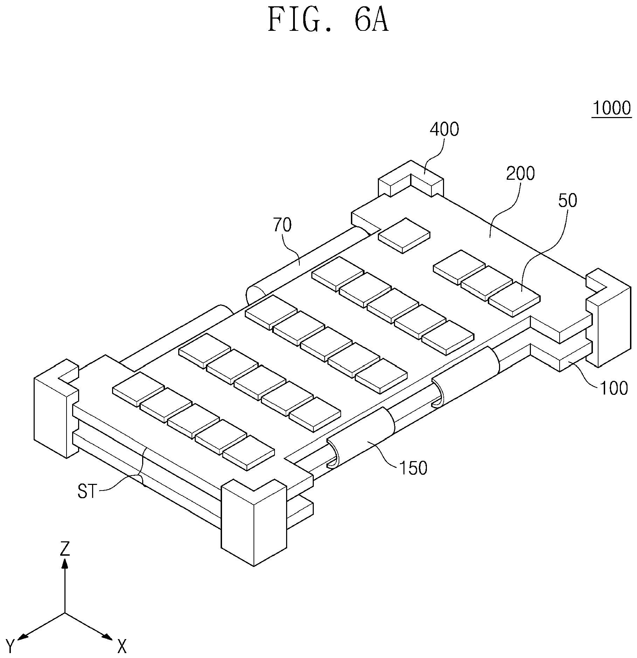

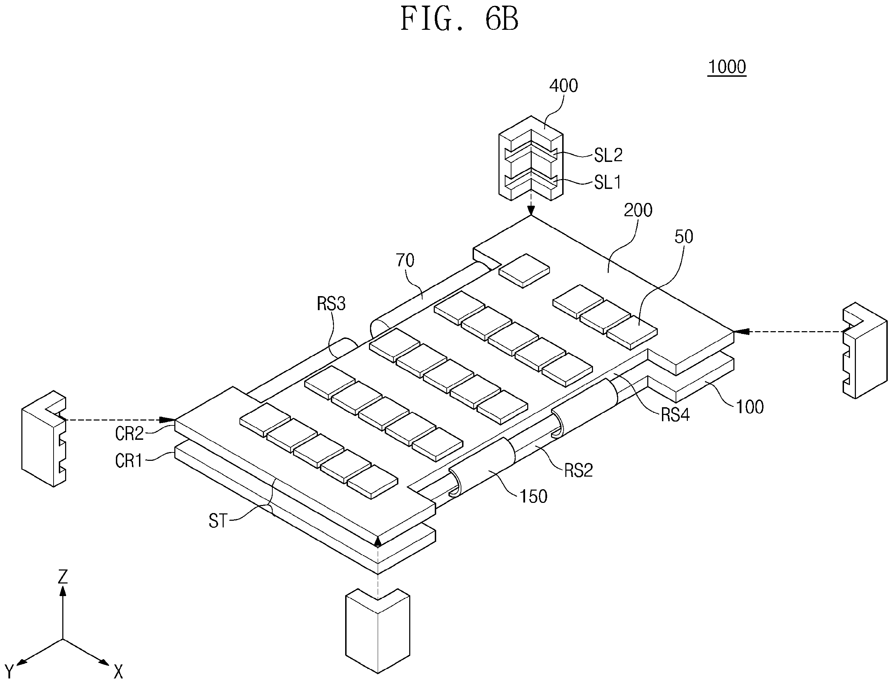

FIG. 6A is a perspective view of the semiconductor memory module of FIG. 1. FIG. 6B is an exploded perspective view of the semiconductor memory module of FIG. 1.

Referring to FIGS. 1, 3, 6A and 6B, the first corners CR1 of the first substrate 100 and the corresponding second corners CR2 of the second substrate 200 may fit into corresponding fixing structures 400. In the present example, four fixing structures 400 may be provided. However, the number of fixing structures 400 in the examples is not limited thereto and may be one or more in other examples. Each of the four corners of the stacked structure ST may be fitted into a corresponding fixing structure 400. The fixing structures 400 may surround the stacked structure ST at each of the four corners.

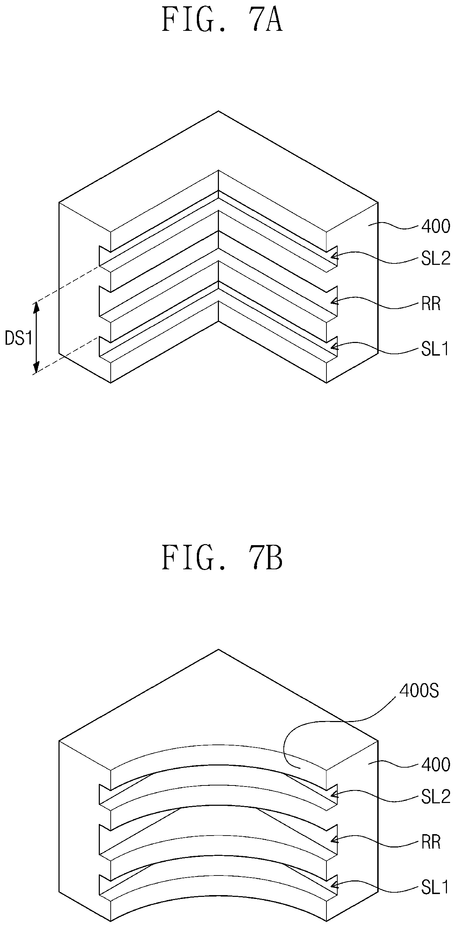

Each of the fixing structures 400 may include a first slot SL1 into which the first corner CR1 is fitted and a second slot SL2 into which the second corner CR2 corresponding to the first corner CR1 is fitted. The fixing structures 400 may fit the first corners CR1 of the first substrate 100 and the corresponding second corners CR2 of the second substrate 200, and thus a distance between the first substrate 100 and the second substrate 200 may be fixed to be constant by the fixing structure 400. The fixing structure 400 may have a single-layer or multi-layer structure formed of and/or including at least one of plastic, fiber, rubber, sponge, urethane, carbon material, ceramic, metal, and porous material. The fixing structure 400 may also be referred to as a 'clip'. The fixing structures 400 may each independently have a length, width, and/or height in the range of 0. 1 mm to 200 mm. A distance (DS 1 in FIG. 7A) between the first slot SL1 and the second corner CR2 or the distance (or pitch) between the center of the first slot SL1 and the center of the second corner CR2 may be in the range of 0.1 mm to 100 mm.

The first flexible connector 150 may apply a downward force to the first substrate 100 and an upward force to the second substrate 200 resulting from an elastic restoring force of the first flexible connector 150. However, the first flexible connector 150 cannot be unfolded within the case 500. Accordingly, the first, second, and fourth semiconductor packages 20, 30, and 50 mounted on the first substrate 100 and the second substrate 200 may be pressed towards the case 500 by the elastic restoring force of the first flexible connector 150. The elastic restoring force of the first flexible connector may result in a physical stress applied to the first, second, and fourth semiconductor packages 20, 30, and 50. The physical stress may be transferred to first, second, and fourth solder balls 12, 14, and 18 interposed between the first, second and fourth semiconductor packages 20, 30 and 50. As a result, solder ball cracks (or solder joint cracks) or pattern cracks in a PCB region may occur. Therefore, reliability of the semiconductor memory module may be deteriorated.

However, in the inventive concepts, the fixing structures 400 may suppress the elastic restoring force of the first flexible connector 150. Accordingly, the physical stress applied to the first, second, and fourth solder balls 12, 14, and 18 may be dispersed, alleviated, and/or reduced, thereby preventing the solder ball cracks. Accordingly, the reliability of the semiconductor memory module may be improved by the fixing structures 400. Additionally, according to the inventive concepts since the corners CR1 and CR2 of the stacked structure ST that are inserted into the fixing structures 400 are generally not areas where the semiconductor packages 20 to 50 are disposed, the space utilization is efficient. Accordingly, the described integrated semiconductor memory module 1000 may provide an improved semiconductor memory module.

FIGS. 7A to 7H are perspective views of fixing structures according to embodiments of the inventive concepts.

Referring to FIG. 7A, the fixing structure 400 may have an 'L' shape or an edge that has a right angle when viewed in a plan view. The fixing structure 400 may further include a recessed portion RR between the first slot SL1 and the second slot SL2. All of the side surfaces of the fixing structure 400 may be straight (e.g., straight).

Alternatively, referring to FIG. 7B, one side surface 400S of the fixing structure 400 may be rounded. When viewed in a plan view, the fixing structure 400 may have an edge that has a curved shape. The curved shape may curve inward towards the fixing structure 400.

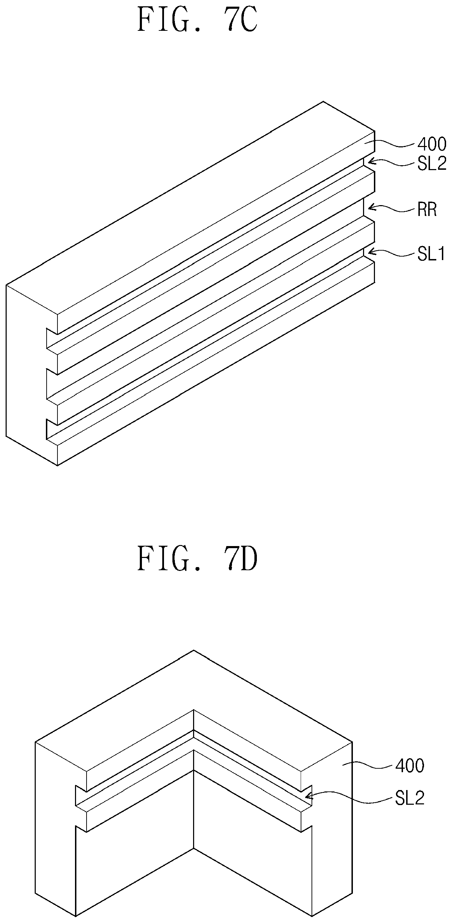

Alternatively, referring to FIG. 7C, the fixing structure 400 may have an 'I' shape that extends in a longitudinal direction. When viewed in a plan view, slots such as first slot SL1 and second slot SL2 may extend linearly without changing direction.

Alternatively, referring to FIG. 7D, the fixing structure 400 may have an 'L' shape when viewed in a plan view. The fixing structure 400 may have a single slot. For example, the fixing structure may exclude the first slot SL1 (e.g., the first slot SL1 is not included).

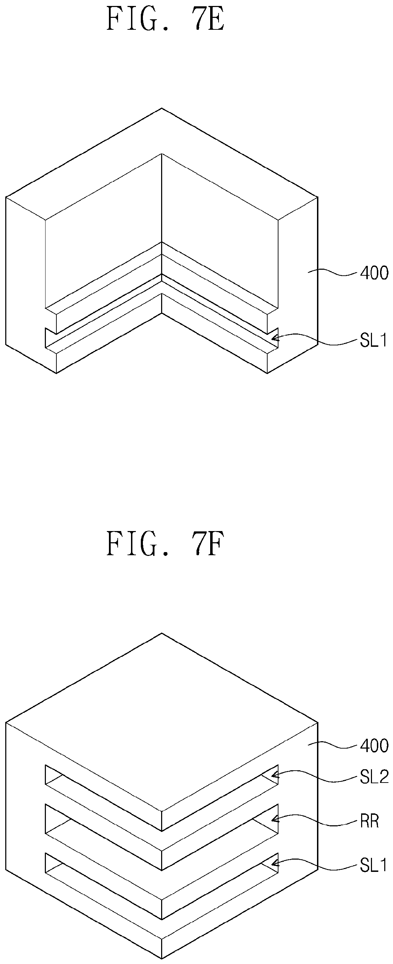

Alternatively, referring to FIG. 7E, the fixing structure 400 may have an 'L' shape when viewed in a plan view. The fixing structure 400 may exclude the second slot SL2 (e.g., the second slot SL2 is not included).

Alternatively, referring to FIG. 7F, the fixing structure 400 may have a rectangular shape when viewed in a plan view.

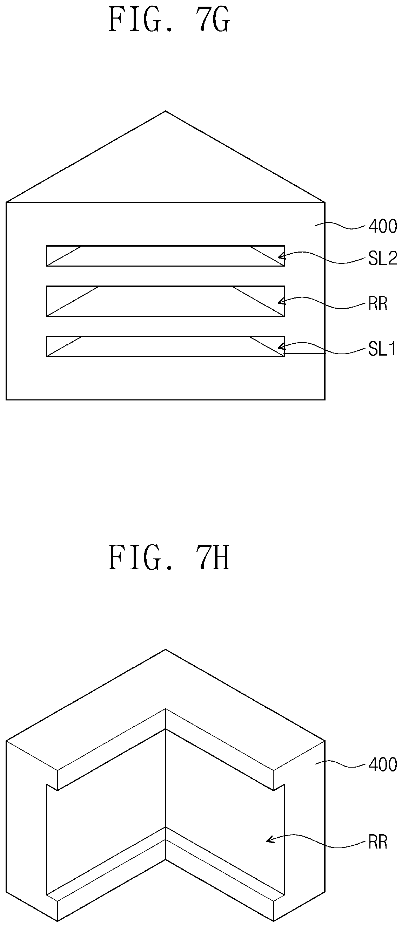

Alternatively, referring to FIG. 7G, the fixing structure 400 may have a right triangle shape when viewed in a plan view.

Alternatively, referring to FIG. 7H, the fixing structure 400 has a structure in which the first slot SL1 and the second slot SL2 are combined with the recessed portion RR. That is, the first corner CR1 of the first substrate 100 and the corresponding second corner CR2 of the second substrate 200 may be inserted into the recessed portion RR.

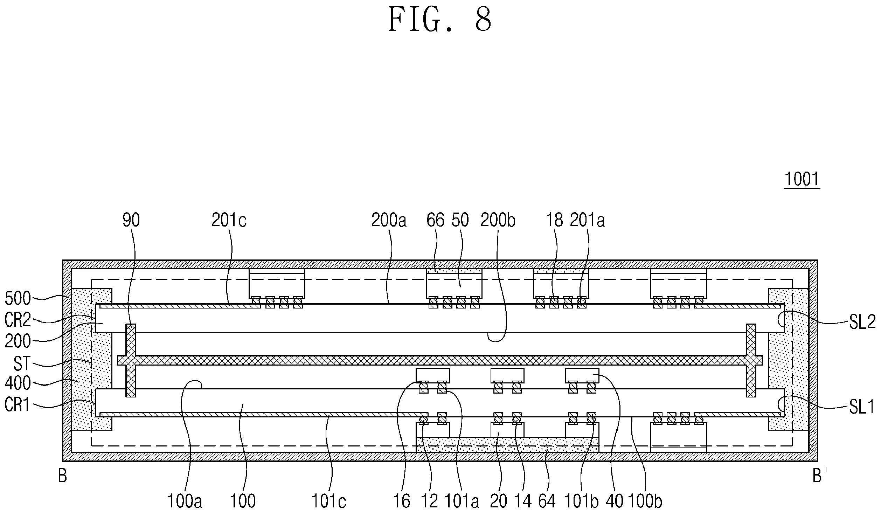

FIG. 8 is a cross-sectional view of FIG. 1 taken along line B-B' according to embodiments of the inventive concepts.

Referring to FIG. 8, in a semiconductor memory module 1001 according to the present example, fixing structures 400 may be formed of metal or a conductive material. The first substrate 100 may further include first lower wirings 101c disposed on the first lower surface 100b and in contact with the fixing structures 400. The second substrate 200 may further include second upper wirings 201c disposed on the second upper surface 200a and in contact with the fixing structures 400. The fixing structure 400 may electrically connect the first lower wiring 101c of the first substrate 100 and the second upper wiring 201c of the second substrate 200. One of the first semiconductor packages 20 may be electrically connected to one of the fourth semiconductor packages 50 by one of the fixing structures 400. The second semiconductor package 30 may be electrically connected to another one of the fourth semiconductor packages 50 by another one of the fixing structures 400. Other structures may be identical to or similar to those described with reference to FIGS. 1 to 7H.

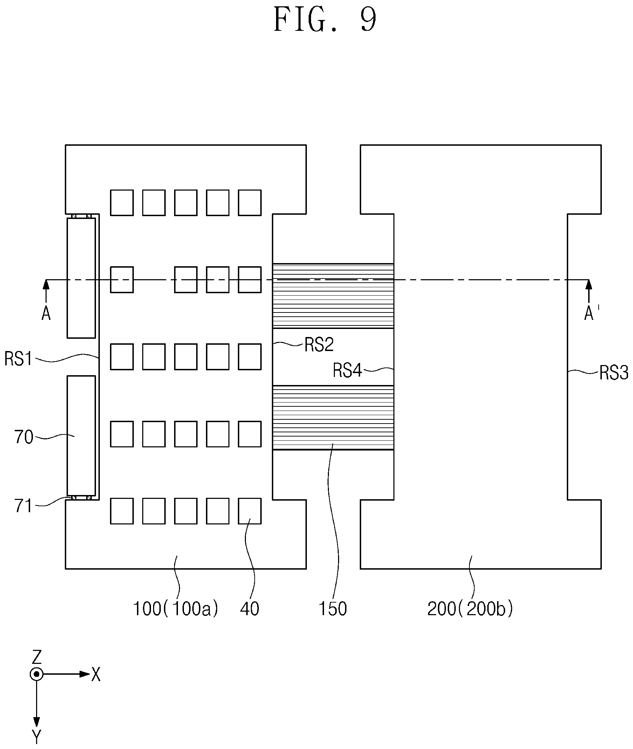

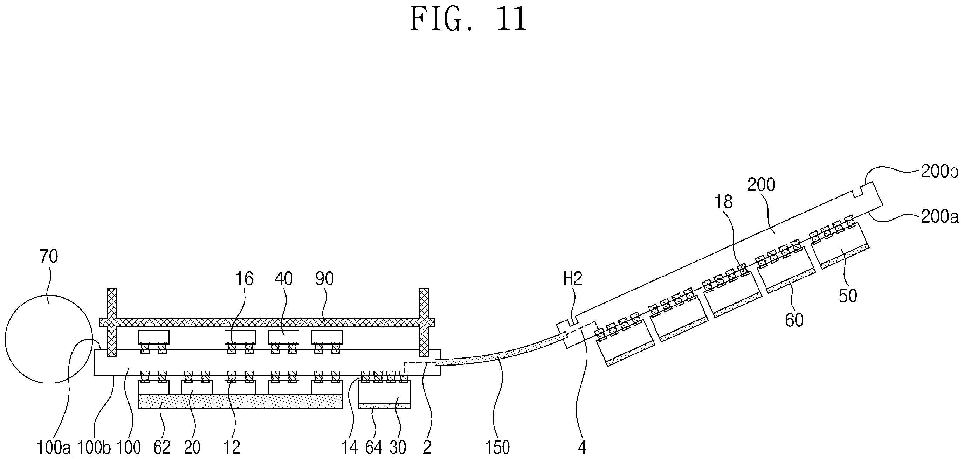

FIG. 9 is a plan view illustrating a state of components of a semiconductor memory module during a process of manufacturing a semiconductor memory module such as the semiconductor memory module shown in FIG. 1. FIG. 10 is a cross-sectional view of FIG. 9 taken along line A-A'. FIG. 11 is a cross-sectional view illustrating the state of components of the semiconductor memory module state during the process of manufacturing a semiconductor memory module.

Referring to FIGS. 9 and 10, a first substrate 100 is prepared. The first substrate 100 may have a first upper surface 100a and a first lower surface 100b. First upper conductive pads 101a are mounted on the first upper surface 100a of the first substrate 100. First lower conductive pads 101b are mounted on the first lower surface 100b of the first substrate 100. First grooves H1 may be formed in the first upper surface 100a of the first substrate 100. A first internal wiring 2 may be disposed in the first substrate 100. The first substrate 100 may have four first corners CR1 arranged in a clockwise direction. The first substrate 100 may have a first side surface RS1 and a second side surface RS2 opposite to each other. When viewed in a plan view, the first side surface RS1 and the second side surface RS2 of the first substrate 100 may be recessed toward the center of the first substrate 100.

The first semiconductor packages 20 are mounted on the first lower surface 100b of the first substrate 100 with first solder balls 12 interposed therebetween. The second semiconductor package 30 is mounted on the first lower surface 100b of the first substrate 100 with second solder balls 14 interposed therebetween. Third semiconductor packages 40 is mounted on the first upper surface 100a of the first substrate 100 with third solder balls 16 interposed therebetween. The third semiconductor packages 40 may be bonded to other portions of the first upper conductive pads 101a. Capacitors 70 are connected to the first side surface RS1 of the first substrate 100.

A second substrate 200 is prepared. The second substrate 200 may have a second upper surface 200a and a second lower surface 200b. The second substrate 200 as viewed in the state of FIG. 10 is inverted such that the upper surface 200a faces downward and the lower surface 200b faces upward. Second upper conductive pads 201a are disposed on the second upper surface 200a of the second substrate 200. A second internal wiring 4 may be disposed in the second substrate 200. Although not shown, second lower conductive pads may also be disposed on the second lower surface 200b of the second substrate 200. Second grooves H2 may be formed in the second lower surface 200b of the second substrate 200. The second substrate 200 may have four second corners CR2 arranged in a clockwise direction.

With the components in place as shown in the state of FIG. 10, the semiconductor memory module 1000 may be folded such that the first top surface 100a of the first substrate 100 faces the second bottom surface 200b of the second substrate 200. After the second substrate 200 is folded over the first substrate 100, each of the second corners CR2 may be positioned over a respective first corner CR1 and may overlap vertically with (or correspond to) the respective first corner CR1. The second substrate 200 may have a third side surface RS3 and a fourth side surface RS4 opposite to each other. When viewed in a plan view, the third side surface RS3 and the fourth side surface RS4 of the second substrate 200 may be recessed toward a center of the second substrate 200. The third side surface RS3 may be disposed over the first side surface RS1 and may overlap vertically with the first side surface RS1. The fourth side surface RS4 may be disposed over the second side surface RS2 and may overlap vertically with the second side surface RS2.

The fourth semiconductor packages 50 are mounted on the second upper surface 200a of the second substrate 200 with fourth solder balls 18 interposed therebetween. The second side surface RS2 of the first substrate 100 is connected to the fourth side surface RS4 of the second substrate 200 by the first flexible connector 150.

A first thermal interface material layer 62 is formed on the first semiconductor packages 20. A second thermal interface material layer 64 is formed on the second semiconductor package 30. Third thermal interface material layers 66 are formed on the fourth semiconductor packages 50, respectively.

Referring to FIG. 11, a first frame 90 is positioned on the first upper surface 100a of the first substrate 100. The first frame 90 is inserted into the first grooves H1. Then, the first flexible connector 150 is bent to place the second substrate 200 on the first substrate 100 as shown in FIGS. 2 and 5B. In this case, the first frame 90 may be inserted into the second grooves H2 of the second lower surface 200b of the second substrate 200. As a result, a stacked structure ST may be formed. In addition, as shown in FIG. 5B, the fixing structures 400 are fitted into the corners CR1 and CR2 of the stacked structure ST. In addition, the stacked structure ST may be inserted into the case 500.

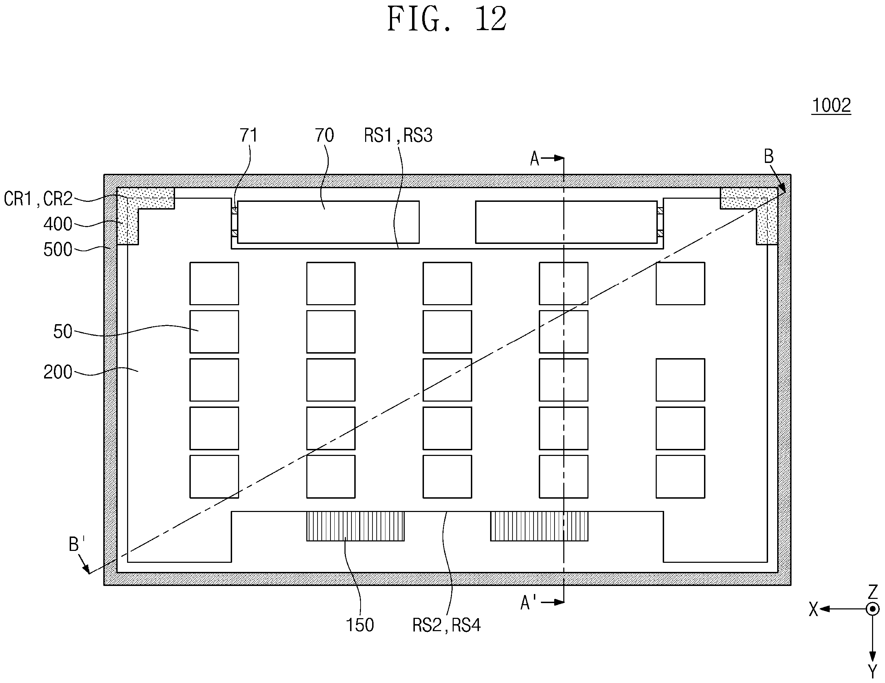

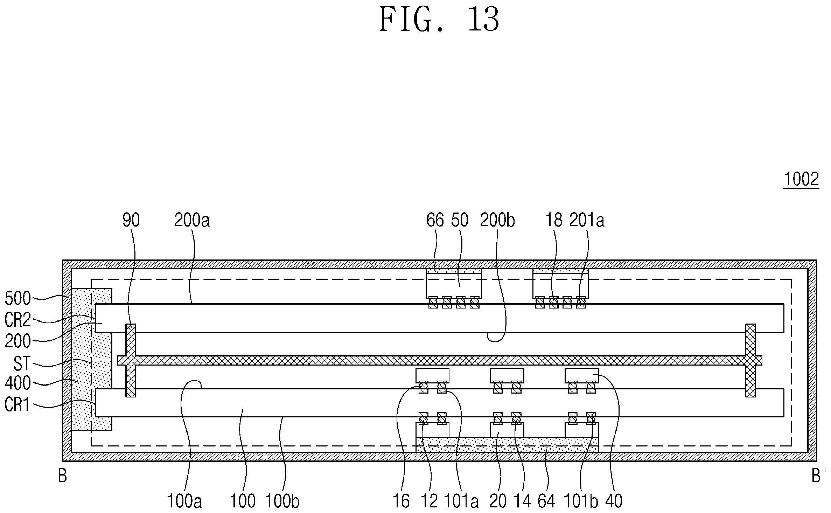

FIG. 12 is a plan view of a semiconductor memory module according to embodiments of the inventive concepts. FIG. 13 is a cross-sectional view of FIG. 12 taken along line B-B' according to embodiments of the inventive concepts. A cross section of FIG. 12 taken along line A-A' may be the identical to or similar to that of FIG. 2.

Referring to FIGS. 12 and 13, in a semiconductor memory module 1002 according to the present example, two fixing structures 400 may be provided.

Two first corners CR1 of the first substrate 100 and the corresponding second corners CR2 of the second substrate 200 may be fitted into the fixing structures 400.. In this example, for the first substrate 100, the two first corners CR1 adjacent to the first side surface RS1 and opposite to the second side surfaces RS2 on which the first flexible connector 150 is disposed may be fitted into the fixing structures 400. The remaining first corners CR1 of the first substrate 100 are not fitted in the fixing structures 400. For the second substrate 200, the two second corners CR2 adjacent to the third side surface RS3 and opposite to the fourth side surfaces RS4 on which the first flexible connector 150 is disposed may be fitted into the fixing structures 400. The remaining second corners CR2 of the second substrate 200 are not fitted in the fixing structures 400. Other structures may be the identical to or similar to those described with reference to FIGS. 1 to 8.

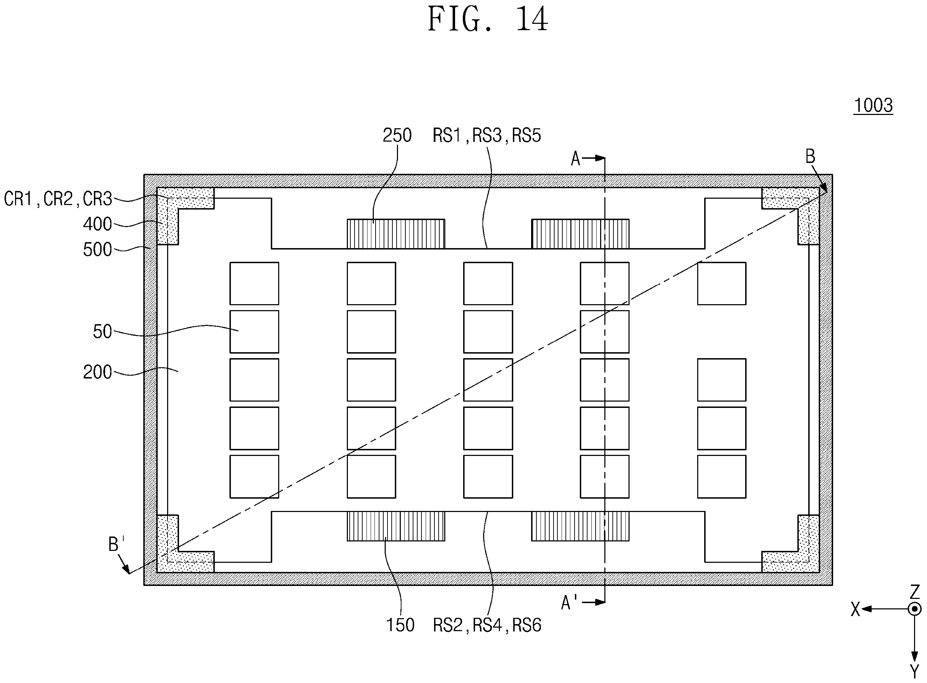

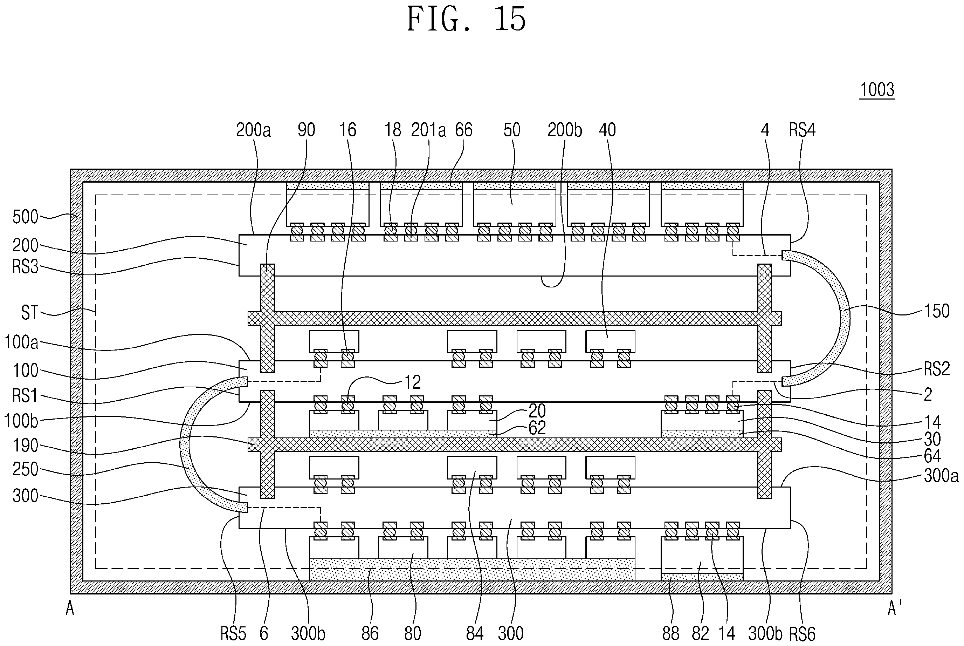

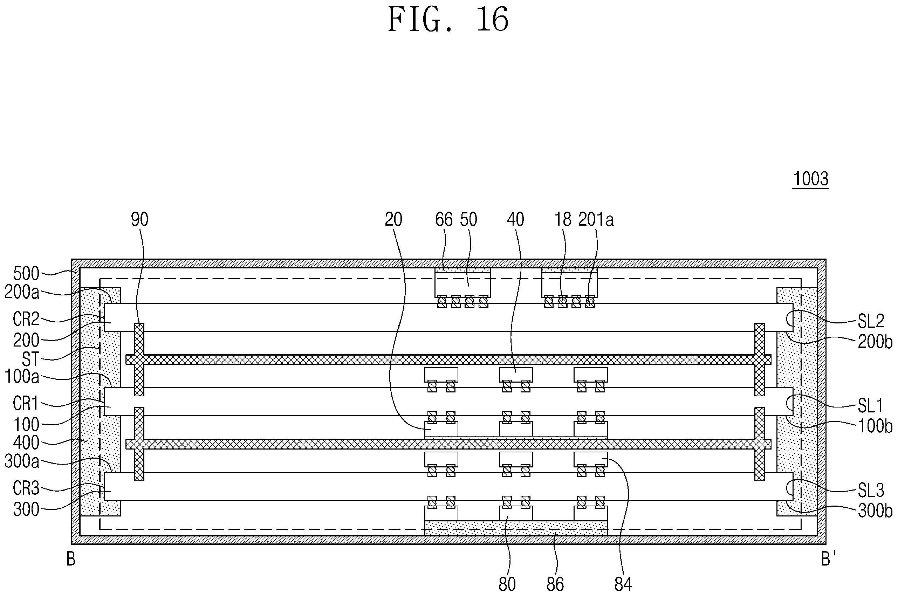

FIG. 14 is a plan view of a semiconductor memory module according to embodiments of the inventive concepts. FIG. 15 is a cross-sectional view of FIG. 14 taken along line A-A' according to embodiments of the inventive concepts. FIG. 16 is a cross-sectional view of FIG. 14 taken along line B-B' according to embodiments of the inventive concepts.

Referring to FIGS. 14 to 16, a semiconductor memory module 1003 according to the present example may exclude the capacitor 70 described with reference to FIGS. 1, 2 and 4. The semiconductor memory module 1003 according to the present example may further include a third substrate 300, a second flexible connector 250, and a second frame 190 disposed under the first substrate 100. The third substrate 300 may be, for example, a double-sided or multi-layered printed circuit board.

The third substrate 300 may have a third upper surface 300a and a third lower surface 300b. A third internal wiring 6 may be disposed in the third substrate 300. The third substrate 300 may have four third corners CR3 arranged in a clockwise direction. The third substrate 300 may have a fifth side surface RS5 and a sixth side surface RS6 opposite to each other. When viewed in a plan view, the fifth side surface RS5 and the sixth side surface RS6 of the third substrate 300 may be recessed toward a center of the third substrate 300.

Fifth semiconductor packages 80 and at least one sixth semiconductor package 82 may be mounted on the third lower surface 300b of the third substrate 300 using solder balls. Seventh semiconductor packages 84 may be mounted on the third upper surface 300a of the third substrate 300 using solder balls.

Each of the fifth to seventh semiconductor packages 80, 82, and 84 may independently be a system large scale integration (LSI) chip or a logic circuit chip, or may be a memory device chip such as a NAND flash memory chip, a DRAM chip, an SRAM chip, an EEPROM chip, a PRAM chip, an MRAM chip, a ReRAM chip, a high bandwidth memory (HBM) chip, a hybrid memory cubic (HMC) chip, or the like, or may be a microelectromechanical system (MEMS) device chip, or an application-specific integrated circuit (ASIC). At least one of the fifth to seventh semiconductor packages 80, 82, and 84 may be replaced with a passive device. The passive element may be a capacitor or resistor.

A fourth thermal interface material layer 86 may be interposed between the fifth semiconductor packages 80 and the case 500. A fifth thermal interface material layer 88 may be interposed between the sixth semiconductor package 82 and the case 500.

The second frame 190 may be interposed between the first substrate 100 and the third substrate 300. The second frame 190 may maintain a gap between the first substrate 100 and the third substrate 300 of at least a certain distance. A portion of the second frame 190 may be inserted into the first substrate 100 and the third substrate 300.

The second flexible connector 250 may connect the recessed first side surface RS1 of the first substrate 100 to the recessed fifth side surface RS5 of the third substrate 300. The structure of the second flexible connector 250 may be identical or similar to the first flexible connector 150 described with reference to FIG. 5A or 5B. The second flexible connector 250 may be provided in plurality.

Corners CR1, CR2, and CR3 of the stacked structure ST may be fitted into the fixing structures 400. The first corners CR1, the second corners CR2, and the third corners CR3 corresponding to each other may be fitted into the fixing structures 400. In the present example, four fixing structures 400 may be provided. The four corners of the stacked structure ST may be fitted into the fixing structures 400. Each the fixing structures 400 may include a first slot SL1 into which a first corner CR1 is inserted, a second slot SL2 into which a second corner CR2 corresponding to the first corner CR1 is inserted, and a third slot SL3 into which a third corner CR3 corresponding to the first corner CR1 is inserted. Other configurations may be the identical to or similar to those described with reference to FIGS. 1 to 8.

In the semiconductor memory module according to the inventive concepts, at least one corner of the stacked structure including a first substrate and a second substrate that are stacked with each other is inserted into the fixing structure. The fixing structure may suppress the elastic restoring force of a flexible connector connecting the side surfaces of the substrates and may fix the first substrate and the second substrate to be spaced apart from each other by a least a certain distance. Accordingly, cracks of the solder balls under the semiconductor packages mounted on the first substrate and the second substrate may be prevented. Accordingly, the reliability of the bump solder joint may be improved, thereby improving the reliability of the semiconductor memory module.

In addition, as the corners of the substrates according to the inventive concepts may be inserted into the fixing structures, the regions where the semiconductor packages are disposed may be avoided, and thus space utilization is efficient. Accordingly, an improved the integrated semiconductor memory module may be provided.

While embodiments are described above, a person skilled in the art may understand that many modifications and variations are made without departing from the spirit and scope of the inventive concepts defined in the following claims. Accordingly, the example embodiments of the inventive concepts should be considered in all respects as illustrative and not restrictive, with the spirit and scope of the inventive concepts being indicated by the appended claims. The embodiments of Fig. 1 through Fig. 16 can be combined with each other.

## Claims

1. A semiconductor memory module comprising:
a first substrate including a first corner;
first semiconductor packages mounted on a lower surface of the first substrate;
a second substrate disposed over the first substrate and including a second corner corresponding to the first corner;
second semiconductor packages mounted on an upper surface of the second substrate; and
a fixing structure in which the first corner and the second corner are fitted.

2. The semiconductor memory module of claim 1,
wherein the first substrate includes a first plurality of corners including the first corner,
wherein the second substrate includes a second plurality of corners including the second corner,
wherein the fixing structure is a first fixing structure, and the semiconductor memory module comprises a plurality of fixing structures including the first fixing structure, and
wherein each fixing structure of the plurality of fixing structures physically supports corresponding corners of the first plurality of corners and the second plurality of corners.

3. The semiconductor memory module of claim 1, wherein the first substrate has a first side surface,
wherein the second substrate has a second side surface disposed over the first side surface, and
wherein the semiconductor memory module further includes at least one first flexible connector connecting the first side surface and the second side surface.

4. The semiconductor memory module of claim 3, wherein each of the first side surface and the second side surface has a recessed portion, and
wherein the first flexible connector is disposed in the recessed portion.

5. The semiconductor memory module of claim 3, wherein the first flexible connector includes:
a first flexible layer and a second flexible layer sequentially stacked;
a first flexible wiring interposed between the first flexible layer and the second flexible layer; and
an active element interposed between the first flexible layer and the second flexible layer and connected to the first flexible wiring.

6. The semiconductor memory module of claim 3, further comprising:
a third substrate disposed below the first substrate;
third semiconductor packages mounted on a lower surface of the third substrate; and
a second flexible connector connecting the third substrate and the first substrate,
wherein the first substrate has a third side surface opposite to the first side surface,
wherein the third substrate has a fourth side surface positioned below the third side surface, and
wherein the second flexible connector connects the third side surface and the fourth side surface.

7. The semiconductor memory module of claim 1, wherein the fixing structure has a multi-layer structure of at least one of plastic, fiber, rubber, sponge, urethane, carbon material, ceramic, metal, and porous material.

8. The semiconductor memory module of claim 1,
wherein the fixing structure is formed of a conductive material,
wherein the semiconductor memory module further includes:
a first conductive pattern disposed on the lower surface of the first substrate and electrically connecting the fixing structure and one of the first semiconductor packages; and
a second conductive pattern disposed on the upper surface of the second substrate and electrically connecting the fixing structure and one of the second semiconductor packages.

9. The semiconductor memory module of claim 1, wherein the fixing structure has an 'L' shape, an 'I' shape, a triangle shape, or a quadrangular shape when viewed in a plan view.

10. The semiconductor memory module of claim 1, wherein
the fixing structure includes:
a first slot in which the first corner of the first substrate is inserted; and
a second slot in which the second corner of the second substrate is inserted.

11. The semiconductor memory module of claim 1,
wherein the first substrate includes a first side recessed portion,
wherein the second substrate includes a second side recessed portion corresponding to the first side recessed portion,
wherein the semiconductor memory module further includes a first capacitor disposed in the first side recessed portion and connected to the first substrate, and
wherein an upper surface of the first capacitor is inserted in the second side recessed portion.

12. The semiconductor memory module of claim 1, further comprising:
a case housing the first substrate, the first semiconductor packages, the second substrate, the second semiconductor packages, and the fixing structure;
a first thermal interface material layer interposed between the first semiconductor packages and the case; and
a second thermal interface material layer interposed between the second semiconductor packages and the case.

13. The semiconductor memory module of claim 12, wherein a density of the first thermal interface material layer is different from a density of the second thermal interface material layer.

14. The semiconductor memory module of claim 12, wherein the thickness of the first thermal interface material layer is different from the thickness of the second thermal interface material layer.

15. The semiconductor memory module of claim 1, further comprising:
a frame interposed between the first substrate and the second substrate; and
third semiconductor packages mounted on an upper surface of the first substrate and spaced apart from the frame.
